# DEMANDE DE BREVET EUROPEEN

(11) **EP 2 339 744 A1**
(43) Date de publication de la demande: **29.06.2011**
(21) Numéro de dépôt: 09179458.6
(22) Date de dépôt: 16.12.2009
(51) Int. Cl.: H03D 7/14

(54) **Circuit mélangeur basse tension pour un dispositif de transmission de signaux UWB**

(71) Demandeur: The Swatch Group Research and Development Ltd., 2074 Marin (CH)
(72) Inventeur: De Rosa, Luca, 2013 Colombier (CH)
(74) Mandataire: Ravenel, Thierry Gérard Louis

(57) **Abrégé**

Le circuit mélangeur basse tension peut être prévu pour équiper un dispositif de transmission de signaux UWB. Le circuit comprend des première et seconde paires différentielles de transistors NMOS (M5, M6, M7, M8), dont la source des transistors (M5, M6) de la première paire est reliée à la sortie d'un premier montage inverseur de transistors MOS (M1, M3) d'un étage à transconductance, et la source des transistors (M7, M8) de la seconde paire est reliée à la sortie d'un second montage inverseur de transistors MOS (M2, M4) de l'étage à transconductance. Le drain du premier transistor NMOS (M5) de la première paire et le drain du second transistor NMOS (M7) de la seconde paire, sont reliés à une première résistance (RO) pour fournir un premier signal de sortie (RFO). Le drain du premier transistor NMOS (M8) de la seconde paire et le drain du second transistor (M6) de la première paire, sont reliés à une seconde résistance (R1) pour fournir un second signal de sortie (RF1). Les première et seconde résistances sont connectées à la borne de potentiel haut (VDD) de la source de tension d'alimentation. La grille des premiers transistors NMOS (M5, M8) des paires différentielles reçoit un premier signal à fréquence porteuse (LOP), alors que la grille des seconds transistors NMOS (M6, M7) des paires différentielles reçoit un second signal à fréquence porteuse (LON). Un premier signal de données (INO) est fourni à l'entrée du premier montage inverseur (M1, M3), alors qu'un second signal de données (IN1) est fourni à l'entrée du second montage inverseur (M2, M4).

## Description

L'invention concerne un circuit mélangeur basse tension pour convertir à haute fréquence des signaux à transmettre par une antenne notamment pour un dispositif de transmission de signaux à ultra large bande (UWB).

Dans un système utilisant la technologie à ultra large bande (UWB), la transmission des données est effectuée par l'intermédiaire de signaux de données UWB, qui comprennent une succession d'impulsions très courtes avec ou sans l'utilisation d'une fréquence porteuse. Il faut généralement comprendre par "données", une information textuelle comprenant un ou plusieurs symboles successifs, une information de synchronisation ou d'autres informations. Comme les impulsions sont très courtes par exemple de durée chacune inférieure ou égale à 2 ns, cela conduit à l'obtention d'un spectre à ultra large bande dans le domaine fréquentiel. Pour une technologie UWB, le spectre défini de fréquences des signaux UWB doit se situer entre 3.1 et 10.6 GHz. Il peut également être prévu de diviser le spectre en plusieurs bandes de fréquence pour définir différents canaux de transmission parmi lesquelles 12 bandes de fréquence de l'ordre de 499.2 MHz.

Pour la reconnaissance du dispositif émetteur UWB par un dispositif récepteur UWB voisin, le codage des séquences d'impulsions des signaux de données transmises est en principe personnalisé au dispositif émetteur. Pour la transmission de données dans les signaux UWB, il peut être utilisé différents types de codage. Il peut être utilisé une modulation de position d'impulsions (PPM), une modulation d'amplitude des impulsions (PAM), une modulation de phase ou à décalage de phase (BPSK) des impulsions, une combinaison de modulation de position et de phase des impulsions, un codage binaire du type On-Off-Keying (OOK) en terminologie anglaise ou un autre type de modulation. La transmission de données par la technologie à ultra-large bande se fait normalement à courte distance avec une faible puissance des impulsions transmises.

Les impulsions de données sont générées dans un circuit de génération d'impulsions commandé par un générateur de données du dispositif de transmission de signaux UWB pour fournir au moins un signal à impulsions de données. Ce signal à impulsions pour les signaux UWB peut être encore converti en fréquence par l'intermédiaire d'un mélangeur. Ce signal à impulsions est donc mélangé dans le mélangeur à au moins un signal à fréquence porteuse d'un oscillateur local. Les signaux fournis par le mélangeur doivent généralement être amplifiés dans un amplificateur supplémentaire, car la dynamique d'émission en sortie du mélangeur n'est souvent pas suffisante. Les signaux amplifiés par l'amplificateur définissent les signaux UWB à transmettre par l'antenne du dispositif de transmission. Cela constitue un inconvénient d'un tel dispositif de l'état de la technique, car cela ne permet de réduire ni le nombre de composants d'un tel dispositif, ni sa consommation électrique.

Une forme d'exécution d'un circuit mélangeur utilisé notamment dans un dispositif de transmission de signaux UWB est définie dans le document de brevet JP 2005-184141. Ce circuit mélangeur permet de convertir à haute fréquence des signaux de données pour la transmission de signaux du type UWB. Le circuit mélangeur est réalisé de manière à pouvoir fonctionner à faible tension par exemple à une tension inférieure à 2 V. Pour ce faire, il comprend deux paires différentielles de transistors MOS montées en série chacune avec un autre transistor MOS et une résistance entre les bornes d'une source de tension d'alimentation. Cela permet de réduire le niveau de ladite tension d'alimentation. Par contre, ce circuit mélangeur ne permet pas de fournir des signaux de sortie ayant une dynamique suffisante. Cela nécessite donc l'utilisation d'un amplificateur en sortie du circuit mélangeur pour amplifier les signaux de sortie pour une transmission de signaux UWB, ce qui constitue un inconvénient.

Une amélioration du circuit mélangeur du précédent document est définie dans le document de brevet US 2009/0174460. Le circuit mélangeur de ce document comprend également deux paires différentielles de transistors NMOS montées en série chacune avec un autre transistor NMOS et une résistance entre les bornes d'une source de tension d'alimentation. Chaque transistor NMOS relié à la paire différentielle de transistors NMOS correspondante est adapté pour supprimer la transconductance du troisième ordre pour obtenir un circuit mélangeur plus linéaire. Même si ce circuit mélangeur peut être prévu pour fonctionner à faible tension, il est néanmoins nécessaire d'utiliser également un amplificateur en sortie du circuit mélangeur pour amplifier les signaux de sortie pour une transmission de signaux UWB, ce qui constitue un inconvénient.

L'invention a donc pour but de pallier aux inconvénients cités ci-devant en fournissant un circuit mélangeur basse tension notamment pour un dispositif de transmission de signaux UWB, permettant d'assurer une dynamique maximale en sortie du circuit mélangeur à basse tension.

A cet effet, l'invention concerne un circuit mélangeur basse tension cité ci-devant, qui comprend les caractéristiques définies dans la revendication indépendante 1.

Des formes d'exécution particulières du circuit mélangeur sont définies dans les revendications dépendantes 2 à 10.

Un avantage du circuit mélangeur basse tension réside dans le fait que l'amplitude de la tension d'un ou des signaux de sortie du circuit mélangeur est augmentée grâce à l'étage à transconductance avec une faible tension d'alimentation. Ceci permet d'avoir une dynamique maximale en sortie du circuit mélangeur même avec une tension d'alimentation, qui peut être inférieure à 1 V. Pour ce faire, uniquement deux transistors sont montés en série entre les deux bornes de la source de tension d'alimentation, pour l'étage à transconductance et pour la combinaison entre l'étage à transconductance et les paires différentielles de transistors.

A cet effet, l'invention concerne également un dispositif de transmission de signaux UWB muni du circuit mélangeur basse tension, qui comprend les caractéristiques définies dans la revendication 11.

Une forme d'exécution particulière du dispositif de transmission de signaux UWB est définie dans la revendication dépendante 12.

Les buts, avantages et caractéristiques du circuit mélangeur basse tension dans un dispositif de transmission de signaux UWB, apparaîtront mieux dans la description suivante sur la base d'au moins une forme d'exécution non limitative illustrée par les dessins sur lesquels :
la figure 1 représente de manière simplifiée un dispositif de transmission de signaux UWB, qui comprend un circuit mélangeur basse tension selon l'invention,
la figure 2 représente une forme d'exécution du circuit mélangeur basse tension selon l'invention pour un dispositif de transmission de signaux UWB, et
la figure 3 représente une forme d'exécution particulière de l'étage à transconductance du circuit mélangeur basse tension selon l'invention.

Dans la description suivante, tous les éléments particuliers du circuit mélangeur basse tension sont définis. Cependant la réalisation de chaque élément dudit circuit mélangeur, qui est bien connue de l'homme du métier dans ce domaine technique, n'est relatée que de manière simplifiée. Ledit circuit mélangeur basse tension peut être de préférence utilisé dans un dispositif de transmission de signaux UWB, mais il peut également être utilisé dans tout autre dispositif de transmission ou de réception de signaux radiofréquences par exemple.

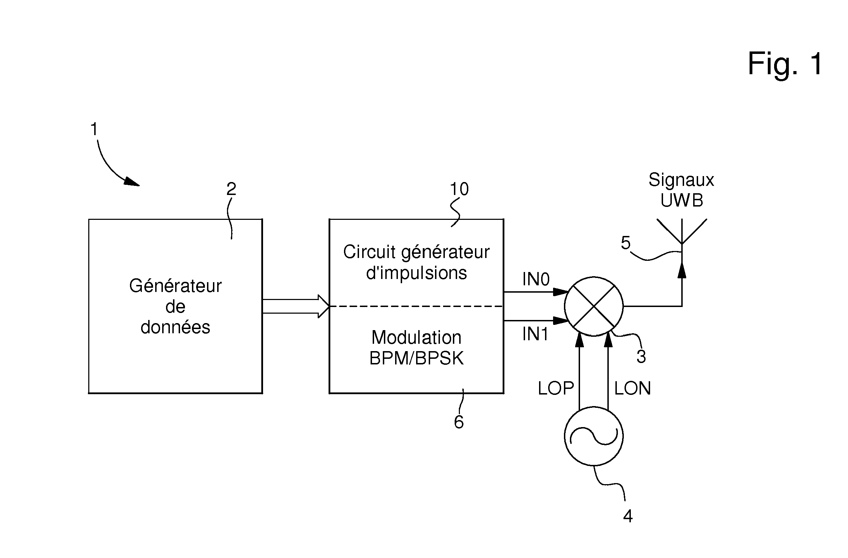

Le dispositif de transmission de signaux UWB 1, qui comprend le circuit mélangeur basse tension 3 selon l'invention, est représenté de manière simplifiée à la figure 1. Ce dispositif de transmission peut être composé d'un générateur de données 2, d'un circuit générateur d'impulsions 10, d'une unité de modulation BPM/BPSK 6 combinée au circuit générateur d'impulsions, d'un oscillateur local 4, d'un circuit mélangeur 3 selon l'invention et d'une antenne 5 pour la transmission des signaux UWB.

Les signaux UWB à fréquence porteuse, qui sont transmis par l'antenne, peuvent être composés d'un préambule de synchronisation et d'une série de symboles de données à la suite du préambule. Les signaux UWB comprennent pour chaque symbole de données transmis une impulsion inférieure à 2 ns ou une rafale d'impulsions modulées en position et en phase, ce qui définit deux bits, et converties en fréquence sur une fréquence porteuse située entre 3.1 GHz et 10.6 GHz. La fréquence porteuse des signaux UWB peut être déterminée pour la transmission des données par exemple dans une parmi les 12 bandes de fréquences de 499.2 MHz dans la largeur de bande de 3.1 GHz et 10.6 GHz du spectre UWB. Il peut être choisi par exemple la fréquence porteuse à 7.9872 GHz.

Dans une phase de transmission de signaux UWB, le générateur de données 2 fournit des signaux numériques de données à l'ensemble composé de l'unité 6 de modulation de position (BPM) et de phase (BPSK) et du circuit générateur d'impulsions 10. Ceci permet au circuit générateur d'impulsions de fournir au moins un signal de sortie à impulsions IN0 pour le circuit mélangeur 3. Au moins un signal à fréquence porteuse LOP de l'oscillateur local 4 est mélangé au signal de sortie du générateur d'impulsions dans le circuit mélangeur 3. Ceci permet de convertir en fréquence le signal de sortie sur la fréquence porteuse. Le circuit mélangeur 3 fournit ainsi au moins un signal de sortie RF0 directement en tant que signaux UWB à impulsions de données à l'antenne de transmission 5 pour être transmis à au moins un dispositif récepteur voisin.

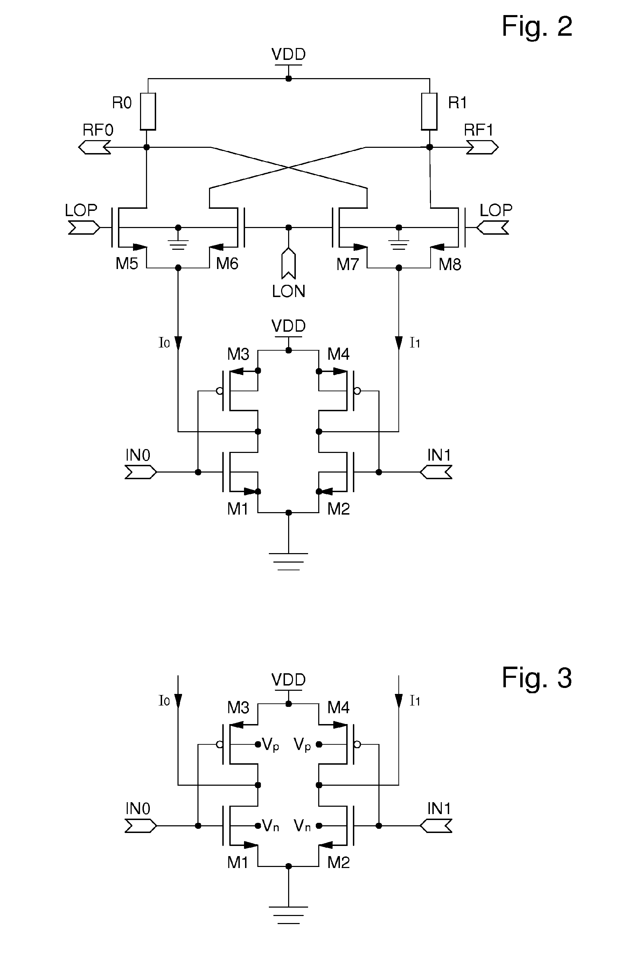

Il est à noter comme expliqué ci-après en référence aux figures 2 et 3, que le circuit mélangeur 3 peut être de préférence configuré pour recevoir deux signaux de sortie à impulsions de données IN0 et IN1 du circuit générateur d'impulsions 10. Les impulsions du premier signal de sortie IN0 sont inversées par rapport aux impulsions du second signal de sortie IN1. Dans le circuit mélangeur 3, le premier signal de sortie à impulsions lN0 est mélangé à un premier signal à fréquence porteuse LOP de l'oscillateur local 4, alors qu'un second signal de sortie IN1 du circuit générateur d'impulsions est mélangé à un second signal à fréquence porteuse LON. Ce second signal à fréquence porteuse de l'oscillateur local 4 est déphasé de 180° par rapport au premier signal à fréquence porteuse. De cette manière, cela renforce les signaux UWB à impulsions de données à transmettre par l'antenne 5 si les deux sorties différentielles sont combinées. Pour ce faire, il peut être prévu en sortie du mélangeur éventuellement un additionneur des signaux de sortie du circuit mélangeur.

Une forme d'exécution du circuit mélangeur basse tension de la présente invention est maintenant décrite de manière plus détaillée en référence à la figure 2. Ce circuit mélangeur basse tension est préférentiellement destiné à faire partie du dispositif de transmission de signaux UWB comme expliqué ci-dessus. Il est alimenté par une source de tension d'alimentation à faible tension, qui peut être inférieure à 1 V, par exemple de l'ordre de 0.9 V. Cela permet de réduire considérablement la consommation du circuit mélangeur par rapport à ceux de l'état de la technique. Un tel circuit mélangeur peut être réalisé sous forme intégrée par exemple dans un substrat de silicium normalement dopé P d'une technologie CMOS à 0.18 µm. Il peut être réalisé dans un même circuit intégré avec le générateur de données, l'unité de modulation BPM/BPSK et le circuit générateur d'impulsions, ainsi qu'une grande partie de l'oscillateur local du dispositif de transmission.

Ce circuit mélangeur basse tension comprend deux impédances, qui sont des résistances R0, R1, deux paires différentielles de transistors NMOS M5, M6, M7 et M8 (premier type de conductivité), qui sont de même dimension et appariés, et un étage à transconductance composé de deux branches de transistors NMOS M1, M2 appariés et PMOS M3, M4 appariés (second type de conductivité). La première branche de l'étage à transconductance comprend un premier transistor NMOS M1, qui est monté en série sous la forme d'inverseur avec un premier transistor PMOS M3 entre deux bornes d'une source de tension d'alimentation VDD non représentée. La seconde branche de l'étage à transconductance comprend un second transistor NMOS M2, qui est monté en série sous la forme d'inverseur avec un second transistor PMOS M4 entre les deux bornes de la source de tension d'alimentation. Chaque transistor MOS comprend une première borne de courant, qui définit la source, une seconde borne de courant, qui définit le drain, une borne de commande, qui définit la grille, et une borne qui définit le contact du caisson ou substrat.

La source des deux transistors NMOS M1 et M2 est reliée à la borne de masse, alors que la source des deux transistors PMOS M3, M4 est reliée à la borne de potentiel haut VDD de la source de tension d'alimentation. Le drain du premier transistor NMOS M1 est relié au drain du premier transistor PMOS M3 dans la première branche pour définir un premier noeud de connexion. Le drain du second transistor NMOS M2 est relié au drain du second transistor PMOS M4 dans la seconde branche pour définir un second noeud de connexion. La grille du premier transistor NMOS M1 est reliée, dans un montage inverseur, à la grille du premier transistor PMOS M3 pour recevoir le premier signal de sortie à impulsions IN0 du circuit générateur d'impulsions. Finalement la grille du second transistor NMOS M2 est reliée, dans un montage inverseur, à la grille du second transistor PMOS M4 pour recevoir le second signal de sortie à impulsions IN1 du circuit générateur d'impulsions.

La source de chaque transistor NMOS M5, M6 de la première paire différentielle est reliée au premier noeud de connexion des premiers transistors NMOS M1 et PMOS M3 de la première branche de l'étage à transconductance. La source de chaque transistor NMOS M7, M8 de la seconde paire différentielle est reliée au second noeud de connexion des seconds transistors NMOS M2 et PMOS M4 de la seconde branche de l'étage à transconductance. Le drain du premier transistor NMOS M5 de la première paire différentielle est relié à une première résistance R0, qui est reliée également à la borne de potentiel haut VDD de la source de tension d'alimentation non représentée. Le drain du second transistor NMOS M6 de la première paire différentielle est relié à une seconde résistance R1, qui est reliée également à la borne de potentiel haut VDD de la source de tension d'alimentation non représentée. Le drain du premier transistor NMOS M8 de la seconde paire différentielle est relié à la seconde résistance R1. Le drain du second transistor NMOS M7 de la seconde paire différentielle est relié à la première résistance R0.

Les grilles des premiers transistors NMOS M5 et M8 des deux paires différentielles sont reliées pour recevoir un premier signal à fréquence porteuse LOP de l'oscillateur local. Les grilles des seconds transistors NMOS M6 et M7 des deux paires différentielles sont reliées pour recevoir un second signal à fréquence porteuse LON de l'oscillateur local. Le second signal à fréquence porteuse LON de forme sinusoïdale est déphasé de 180° par rapport au premier signal à fréquence porteuse LOP de forme sinusoïdale. De ce fait, les premiers transistors NMOS M5 et M8 sont rendus conducteur, alors que les seconds transistors NMOS M6 et M7 sont rendus non conducteur, quand le premier signal à fréquence porteuse LOP est à un niveau de tension supérieur au second signal à fréquence porteuse LON. Inversement les seconds transistors NMOS M6 et M7 sont rendus conducteur, alors que les premiers transistors NMOS M5 et M8 sont rendus non conducteur, quand le second signal à fréquence porteuse LON est à un niveau de tension supérieur au premier signal à fréquence porteuse LOP. Comme les signaux à fréquence porteuse sont de forme sinusoïdale, il y a bien entendu une transition de conduction non brutale entre les premiers et seconds transistors NMOS des paires différentielles.

Un premier signal de sortie RFO, qui compose les signaux UWB, est fourni au noeud de connexion de la première résistance R0 avec le premier transistor NMOS M5 de la première paire différentielle et le second transistor NMOS M7 de la seconde paire différentielle. Un second signal de sortie RF1, qui compose les signaux UWB, est fourni au noeud de connexion de la seconde résistance R1 avec le premier transistor NMOS M8 de la seconde paire différentielle et le second transistor NMOS M6 de la première paire différentielle.

Lorsque le premier signal de sortie à impulsions IN0 est à un niveau haut de tension par exemple proche de VDD, le premier transistor NMOS M1 est rendu conducteur, alors que le premier transistor PMOS M3 est rendu non conducteur dans ce montage inverseur. Dans ce cas, le second signal de sortie à impulsions IN1 est à un niveau bas de tension par exemple proche de la masse. Ainsi, le second transistor NMOS M2 est rendu non conducteur, alors que le second transistor PMOS M4 est rendu conducteur dans ce montage inverseur. Un courant I₀ circule à travers le premier transistor NMOS M1 et à travers un des transistors NMOS M5, M6 de la première paire différentielle. Ce courant I₀ traverse encore soit la première résistance R0, soit la seconde résistance R1 de même valeur résistive que la première résistance. La valeur de ce courant I₀ est dépendante de la valeur de chaque résistance R0, R1, qui peut être de l'ordre de 50 Ohms pour être adaptée à l'impédance d'antenne. Par contre, aucun courant I₁ ne circule dans la seconde paire différentielle de transistors NMOS M7, M8.

Inversement lorsque le second signal de sortie IN1, est à un niveau haut de tension par exemple proche de VDD, le second transistor NMOS M2 est rendu conducteur, alors que le second transistor PMOS M4 est rendu non conducteur. Dans ce cas, le premier signal de sortie à impulsions IN0 est à un niveau bas de tension par exemple proche de la masse, ce qui fait que le premier transistor NMOS M1 est rendu non conducteur, alors que le premier transistor PMOS M3 est rendu conducteur. Ainsi, un courant I₁ circule à travers le second transistor NMOS M2 et à travers un des transistors NMOS M7, M8 de la seconde paire différentielle. Ce courant I₁ traverse encore soit la première résistance R0, soit la seconde résistance R1. La valeur du courant I₁ est dépendante de la valeur de chaque résistance R0, R1. Par contre, aucun courant I₀ ne circule dans la première paire différentielle de transistors NMOS M5, M6.

Les signaux de sortie à impulsions IN0 et IN1 fournis par le circuit générateur d'impulsions peuvent être modulés avec un codage ternaire de l'information. Dans ce cas quand un des signaux de sortie à impulsions est à l'état haut, il est défini un état "1 ", alors que quand il est à l'état bas proche de la masse, il est défini un état "-1 ". L'état "0" est défini quand le niveau de tension des signaux de sortie à impulsions se trouve à VDD/2. Dans ce dernier cas, aucun des transistors MOS de l'étage à transconductance n'est rendu conducteur étant donné que la tension de grille sur chacun de ces transistors MOS est inférieure au seuil de conduction. Ainsi, les signaux de sortie du circuit mélangeur RF0 et RF1 se trouvent proches du potentiel haut VDD de la source de tension d'alimentation.

Dans cette première forme d'exécution du circuit mélangeur présentée à la figure 2, le potentiel du substrat ou caisson des transistors PMOS M3 et M4 de l'étage à transconductance est fixé au potentiel haut VDD de la source de tension d'alimentation. Le potentiel du substrat ou caisson des transistors NMOS M1 et M2 de l'étage à transconductance est fixé au potentiel de masse de la source de tension d'alimentation. Il en est de même pour le potentiel du substrat ou caisson des transistors NMOS M5, M6, M7 et M8 des paires différentielles comme montré à la figure 2. Comme le circuit intégré du mélangeur peut être réalisé dans un substrat silicium de type P, c'est donc le potentiel du caisson des transistors PMOS, qui est fixé au potentiel haut, alors qu'il s'agit du potentiel du substrat des transistors NMOS, qui est fixé au potentiel bas.

Grâce au montage sous forme d'inverseur de transistors NMOS et PMOS dans les deux branches de l'étage à transconductance, cela garantit une bonne amplification des signaux de sortie RF0 et RF1 du circuit mélangeur. Cela assure donc une grande dynamique d'émission à basse tension d'alimentation. Dans ces conditions, il n'est pas nécessaire de monter encore un amplificateur en sortie du circuit mélangeur pour transmettre les signaux UWB par l'antenne du dispositif de transmission.

Une modification de l'amplification du circuit mélangeur par l'intermédiaire de l'étage à transconductance peut être effectuée en jouant également sur le potentiel du substrat et caisson des transistors MOS de l'étage à transconductance comme illustré à la figure 3. Il est à noter que les transistors de cette figure 3, qui correspondent à ceux de la figure 2, portent des signes de référence identiques. De ce fait par simplification, il ne sera pas répété la description de ces transistors et de leur branchement aux paires différentielles pour le courant I₀ et I₁.

En modifiant le potentiel Vp du substrat ou caisson des transistors PMOS M3 et M4 et/ou le potentiel Vn du substrat ou caisson des transistors NMOS M1 et M2, il est possible de modifier l'amplification sur les signaux de sortie RF0, RF1 du circuit mélangeur. Ce gain d'amplification supplémentaire sur les signaux de sortie RF0, RF1 permet d'éviter le montage d'un amplificateur de signaux en sortie du circuit mélangeur pour fournir les signaux UWB à transmettre. Pour montrer cette influence du potentiel Vp et/ou Vn des transistors MOS de l'étage à transconductance, il est indiqué certaines valeurs de tension dans le tableau ci-dessous. La tension d'alimentation VDD du circuit mélangeur est fixée inférieure à 1 V, par exemple à 0.9 V. Dans ce tableau, il est indiqué l'amplitude maximale de variation de la tension de sortie Vout (RFO, RF1) en fonction du potentiel de substrat ou caisson Vn des transistors NMOS et du potentiel de substrat ou caisson Vp des transistors PMOS.

| Vn NMOS [V] | Vp PMOS = 0.5 V Vout (RFO, RF1) [mV] | Vp PMOS = VDD = 0.9 V Vout (RFO, RF1) [mV] |
|---|---|---|
| -0.5 | 420 | 330 |
| -0.25 | 390 | 290 |
| 0 | 340 | 220 |
| 0.25 | 270 | 160 |
| 0.5 | 220 | 130 |

A titre d'exemple, le potentiel de substrat Vn des transistors NMOS peut être fixé au potentiel bas de la source de tension d'alimentation, c'est-à-dire à 0 V. Dans ce cas, l'amplitude des signaux de sortie RF du circuit mélangeur peut être une fois et demie plus importante pour un potentiel de caisson Vp des transistors PMOS à 0.5 V par rapport à un potentiel de caisson des transistors PMOS à 0.9 V. Le potentiel à 0.9 V correspond au potentiel haut VDD de la source de tension d'alimentation. Bien entendu, un même potentiel de caisson des transistors PMOS M3 et M4 doit être appliqué. Il en est de même pour le potentiel de substrat des transistors NMOS M1 et M2.

Il est à noter encore que le circuit mélangeur décrit ci-dessus est d'une structure bien linéaire. Il est de ce fait très utile sur une large bande de fréquences, c'est pourquoi il est de préférence utilisé dans un dispositif de transmission de signaux UWB. De plus, comme uniquement des ensembles de deux transistors MOS sont montés en série entre les deux bornes de la source de tension d'alimentation, le circuit mélangeur peut être alimenté à très basse tension en dessous de 1 V, par exemple à 0.9 V.

Bien entendu, il peut être envisagé de brancher inversement tous les composants décrits notamment dans la figure 2. Cependant tous les transistors NMOS de cette figure 2 doivent être remplacés par des transistors PMOS, et tous les transistors PMOS de cette figure 2 doivent être remplacés par des transistors NMOS. Les résistances sont par contre reliées à la borne de potentiel bas de la source de tension d'alimentation.

Il peut encore être envisagé d'utiliser d'autres impédances qu'uniquement des résistances. Une première inductance peut remplacer la première résistance et une seconde inductance peut remplacer la seconde résistance. Une combinaison d'une résistance en parallèle ou en série avec une inductance peut également être envisagée.

A partir de la description qui vient d'être faite, plusieurs variantes du circuit mélangeur basse tension notamment dans un dispositif de transmission de signaux UWB peuvent être conçues par l'homme du métier sans sortir du cadre de l'invention définie par les revendications. Il peut être utilisé des transistors bipolaires à la place des transistors MOS. Dans ces conditions, chaque transistor PMOS d'un premier type de conductivité ou d'un second type de conductivité est remplacé par un transistor PNP, alors que chaque transistor NMOS d'un second type de conductivité ou d'un premier type de conductivité est remplacé par un transistor NPN. La première borne de courant est l'émetteur, la seconde borne de courant est le collecteur et la borne de commande est la base de ces transistors bipolaires. Dans le cas d'un unique signal à impulsions du circuit générateur d'impulsions à mélanger à un unique signal à fréquence porteuse de l'oscillateur, un seul inverseur est prévu, qui est relié à un unique transistor MOS commandé par le signal à fréquence porteuse. Une seule résistance en série avec le transistor MOS et l'inverseur, peut ainsi être prévue pour la fourniture d'un unique signal de sortie du circuit mélangeur. La structure du circuit mélangeur peut également être utilisée pour un dispositif de réception de signaux radiofréquences ou de signaux UWB.

## Revendications

1. Circuit mélangeur basse tension (3), notamment pour un dispositif de transmission de signaux UWB (1), le circuit mélangeur comprenant :
- un étage à transconductance (M1, M3),
- au moins un transistor (M5), dont une première borne de courant est reliée à un noeud de connexion de l'étage à transconductance, dont une seconde borne de courant est reliée à une impédance (RO) pour fournir un signal de sortie (RFO), et dont une borne de commande du transistor (M5) est destinée à recevoir un signal (LOP) d'un oscillateur (4), le transistor relié au noeud de connexion de l'étage à transconductance, et l'impédance étant montés en série entre deux bornes d'une source de tension d'alimentation (VDD),
**caractérisé en ce que** l'étage à transconductance comprend un montage inverseur de transistors (M1, M3), dont l'entrée du montage inverseur est destinée à recevoir un signal de données (IN0), et dont la sortie du montage inverseur est le noeud de connexion relié à la première borne de courant du transistor (M5).

2. Circuit mélangeur basse tension (3) selon la revendication 1, le circuit mélangeur comprenant :
- l'étage à transconductance (M1, M2, M3, M4),
- une première paire différentielle de transistors (M5, M6) d'un premier type de conductivité, dont une première borne de courant des transistors est reliée à un premier noeud de connexion de l'étage à transconductance, dont une seconde borne de courant d'un premier transistor (M5) de la première paire différentielle est reliée à une première impédance (RO) pour fournir un premier signal de sortie (RFO) et dont une seconde borne de courant d'un second transistor (M6) de la première paire différentielle est reliée à une seconde impédance (R1) pour fournir un second signal de sortie (RF1),
- une seconde paire différentielle de transistors (M7, M8) d'un premier type de conductivité, dont une première borne de courant des transistors est reliée à un second noeud de connexion de l'étage à transconductance, dont une seconde borne de courant d'un premier transistor (M8) de la seconde paire différentielle est reliée à la seconde impédance (R1) pour fournir le second signal de sortie (RF1) et dont une seconde borne de courant d'un second transistor (M7) de la seconde paire différentielle est reliée à la première impédance (RO) pour fournir le premier signal de sortie (RFO),
une borne de commande de chaque premier transistor (M5, M8) des première et seconde paires différentielles étant destinée à recevoir un premier signal (LOP) d'un oscillateur (4), et une borne de commande de chaque second transistor (M6, M7) des première et seconde paires différentielles étant destinée à recevoir un second signal (LON) d'un oscillateur (4),
les paires différentielles de transistors reliés aux noeuds de connexion de l'étage à transconductance, et les impédances étant montés en série entre deux bornes d'une source de tension d'alimentation (VDD),
**caractérisé en ce que** l'étage à transconductance comprend un premier montage inverseur de transistors (M1, M3), dont l'entrée du premier montage inverseur est destinée à recevoir un premier signal de données (IN0), et dont la sortie du premier montage inverseur est le premier noeud de connexion relié à la première paire différentielle de transistors, et un second montage inverseur de transistors (M2, M4), dont l'entrée du second montage inverseur est destinée à recevoir un second signal de données (IN1), et dont la sortie du second montage inverseur est le second noeud de connexion relié à la seconde paire différentielle de transistors.

3. Circuit mélangeur basse tension (3) selon la revendication 2, **caractérisé en ce que** les transistors des première et seconde paires différentielles sont des transistors MOS, dont la première borne de courant est la source, dont la seconde borne de courant est le drain, et dont la borne de commande est la grille.

4. Circuit mélangeur basse tension (3) selon la revendication 3, **caractérisé en ce que** les transistors MOS des deux paires différentielles sont des transistors du type NMOS.

5. Circuit mélangeur basse tension (3) selon la revendication 2, **caractérisé en ce que** la première impédance est une première résistance (RO), et **en ce que** la seconde impédance est une seconde résistance (R1).

6. Circuit mélangeur basse tension (3) selon la revendication 2, **caractérisé en ce que** la première impédance est une première inductance, et **en ce que** la seconde impédance est une seconde inductance.

7. Circuit mélangeur basse tension (3) selon l'une des revendications 2 à 4, **caractérisé en ce que** le premier montage inverseur comprend un premier transistor du type NMOS (M1) monté en série avec un premier transistor du type PMOS (M3) entre les deux bornes d'une source de tension d'alimentation, le drain du premier transistor NMOS étant relié au drain du premier transistor PMOS pour définir le premier noeud de connexion relié à la première paire différentielle de transistors, alors que la grille du premier transistor NMOS (M1) est reliée à la grille du premier transistor PMOS (M3) pour recevoir le premier signal de données (INO), et **en ce que** le second montage inverseur comprend un second transistor du type NMOS (M2) monté en série avec un second transistor du type PMOS (M4) entre les deux bornes d'une source de tension d'alimentation, le drain du second transistor NMOS étant relié au drain du second transistor PMOS pour définir le second noeud de connexion relié à la seconde paire différentielle de transistors, alors que la grille du second transistor NMOS (M2) est reliée à la grille du second transistor PMOS (M4) pour recevoir le second signal de données (IN1).

8. Circuit mélangeur basse tension (3) selon la revendication 7, **caractérisé en ce qu'**il est intégré dans un substrat de silicium, **en ce que** le potentiel de substrat ou de caisson des transistors NMOS est fixé au potentiel bas de la source de tension d'alimentation, et **en ce que** le potentiel de substrat ou de caisson des transistors PMOS est fixé au potentiel haut de la source de tension d'alimentation.

9. Circuit mélangeur basse tension (3) selon la revendication 7, **caractérisé en ce qu'**il est intégré dans un substrat de silicium, **en ce que** le potentiel de substrat ou de caisson des transistors NMOS (M1, M2) de l'étage à transconductance est fixé à un premier potentiel adapté entre le potentiel bas et le potentiel haut de la source de tension d'alimentation, et **en ce que** le potentiel de substrat ou de caisson des transistors PMOS (M3, M4) de l'étage à transconductance est fixé à un second potentiel adapté entre le potentiel bas et le potentiel haut de la source de tension d'alimentation.

10. Circuit mélangeur basse tension (3) selon l'une des revendications précédentes, **caractérisé en ce qu'**il est intégré dans un substrat de silicium dopé P d'une technologie CMOS à 0.18 µm.

11. Dispositif de transmission de signaux UWB (1) comprenant un circuit générateur d'impulsions (10), qui est combiné à une unité (6) de modulation de position et de phase des impulsions ou rafales d'impulsions de données, un générateur de données (2) pour fournir des signaux numériques de commande au circuit générateur d'impulsions et à l'unité de modulation de position et de phase des impulsions ou rafales d'impulsions, un oscillateur local (4) et un circuit mélangeur (3) selon l'une des revendications précédentes pour recevoir au moins un signal de données (IN0) du circuit générateur d'impulsions à mélanger à au moins un signal à fréquence porteuse (LOP) de l'oscillateur local afin de fournir directement au moins un signal de sortie (RFO) à une antenne (5) pour la transmission des signaux UWB.

12. Dispositif de transmission de signaux UWB (1) selon la revendication 11, **caractérisé en ce que** l'oscillateur local (4) fournit deux signaux à fréquence porteuse (LOP, LON) déphasés de 180° l'un de l'autre afin de les mélanger dans le circuit mélangeur (3) chacun respectivement à un premier signal de données (INO) et à un second signal de données (IN1) du circuit générateur d'impulsions (10), **en ce que** le premier signal de données est un premier signal de sortie à impulsions (INO), qui est modulé selon un codage ternaire, et **en ce que** le second signal de données est un second signal de sortie à impulsions (IN1), qui est modulé selon un codage ternaire, le second signal de sortie à impulsions étant complémentaire au premier signal de sortie à impulsions.
